Europäisches Patentamt

European Patent Office

Office européen des brevets

(19)

(11) Veröffentlichungsnummer: **0 030 329**
**A2**

# (12) EUROPÄISCHE PATENTANMELDUNG

(21) Anmeldenummer: **80107409.7**

(22) Anmeldetag: **27.11.80**

(51) Int. Cl.³: **H 03 J 9/00**

(30) Priorität: **05.12.79 DE 2948890**

(43) Veröffentlichungstag der Anmeldung: **17.06.81**
**Patentblatt 81/24**

(84) Benannte Vertragsstaaten: **AT IT NL**

(71) Anmelder: **PREH, Elektrofeinmechanische Werke Jakob Preh Nachf. GmbH & Co., Postfach 1740, Schweinfurter Strasse 5 D-8740 Bad Neustadt/Saale (DE)**

(72) Erfinder: **Rüttiger, Anton, Haus-Nr. 50, D-8789 Oberbach (DE)**

(54) **Schaltungsanordnung für eine Fernbedienungseinrichtung.**

(57) Eine Fernbedienungseinrichtung für Rundfunk- und Fernsehempfänger besteht aus mehreren, durch eine elektronische Schaltung miteinander verbundenen integrierten Schaltungen, von denen eine ein Analogwertspeicher (1) und eine andere ein Programmspeicher (2) ist. Damit der Programmspeicher und der der Feinabstimmung dienende Analogwertspeicher auch bei Netzausfall ihre Information nicht verlieren, hängen beide Speicher an einem Nickel-Cadmium-Akkumulator (4). Zur längeren Erhaltung des Speicherinhaltes bei dieser Betriebsart (Netz aus) wird eine elektronische Schaltung vorgeschlagen, bei der einer der Steuereingänge (LCA) des Analogwertspeichers (1) nicht, wie vom Hersteller der integrierten Schaltung in einer Applikationsschrift empfohlenen, über einen Widerstand an das Bezugspotential Masse sondern nur über Widerstände (5, 7, 9) mit dem Akkumulator (4) verbunden ist.

**P r e h**
**Elektrofeinmechanische Werke**
**Jakob Preh Nachf. GmbH & Co.**
**Postfach 1740**
**8740 Bad Neustadt/Saale**                    **, den 22.11.1979**

**15/79 Pt.**
**Bsch/Gü**

### Schaltungsanordnung für eine
### Fernbedienungseinrichtung

Die Erfindung geht von einer Schaltungsanordnung für eine Fernbedienungseinrichtung eines Rundfunk- oder Fernsehempfängers nach dem Oberbegriff des Anspruches 1 aus.

Vor der Einführung der elektronischen Abstimmtechnik in Rundfunk- oder Fernsehempfängern wurden die einzelnen Sender in einem Drucktastenaggregat mit Hilfe mehrerer Spindelwiderstände durch Handabstimmung eingestellt und gespeichert. Durch Drücken eines der vorhandenen Druckdrehknöpfe wurde die an dem jeweiligen Spindelwiderstand abgegriffene Spannung zu Kapazitätsdioden durchgeschaltet. Die Bandumschaltung konnte ebenfalls mit diesen Druckdrehknöpfen vorgenommen werden. Dieses mechanische Abstimmsystem war mit Aufkommen der Fernbedienung für diese weniger geeignet. Man hat daher bald nach elektronischen Lösungen gesucht. Da man inzwischen in der Lage war, preisgünstig auch spezielle integrierte Schaltungen herstellen zu können, sind eine Reihe von Systemen von elektronischen Fernbedienungseinrichtungen mit Ultraschall- oder Infrarotwellen entwickelt worden.

Es sind bereits digitale Abstimmsysteme mit Frequenzsynthese bekannt, bei denen der gewünschte Kanal durch digitale Messung der Oszillatorfrequenz des Kanalwählers von fern mit Hilfe von Ultraschall oder Infrarotlicht eingestellt werden kann. Für den Abgleich wird eine der Oszillatorfrequenz proportionale Zahl mit einer im Speicher für den gewünschten Kanal vorprogrammierten Zahl verglichen. Ein solches System wird TRD-System (Tuning Remote Digital) genannt. Die Bandumschaltung erfolgt automatisch, so daß keine Kenntnis über die Zuordnung der Kanäle zu den einzelnen Bändern erforderlich ist. Kanal- und Programmnummer werden auf dem Bildschirm farbig angezeigt. Alle Bedienfunktionen bzw. Befehle werden in ein binäres Codewort umgewandelt und einer seriellen Datenleitung dem I- oder Instruktions-Bus zugeführt. Für das System steht eine Reihe von integrierten Schaltungen zur Verfügung. Die Regelschleife der digitalen Abstimmung wird von einem Kanalwähler, einem Frequenzteiler und einem Frequenzkomparator mit ROM, in dem sämtliche Bildträgerfrequenzen in binärcodierter Form gespeichert sind, gebildet. Die ROM-Adressen werden vom I-Bus über eine integrierte Schaltung SAB 2015 geliefert, deren Programmspeicher RAM auf 16 Programme programmiert werden kann. Mit der integrierten Schaltung SAB 2022 ist zusätzlich eine Steuerschaltung vorhanden, die eine Analogspannung zur Feinabstimmung des ZF/AFC-Moduls liefert. Die Abstimmspannung für den Kanalwähler wird mit Hilfe der vom ZF/AFC-Modul gelieferten AFC-Spannung im gewünschten Maße nachgestellt. Damit die im Programmspeicher SAB 2015 und im 16-fach Analogwertspeicher SAB 2022 zur Feinabstimmung nachträglich eingeschriebenen Informationen auch bei Netzausfall nicht verloren gehen, hängen beide Speicher an einem Nickel-Cadmium-Akkumulator. Der in LOCMOS-Schaltung aufgebaute Analogspeicher SAB 2022 enthält nach Angabe des Herstellers einen 16 x 5 bit Schreib/Lesespeicher (RAM) zur Speicherung binär codierbarer Analogwerte, einen Digital/ Analog-Umsetzer und eine Ablaufsteuerung. Jeder Analogwert wird mit einer 4-bit-Adresse an den Adreß-Eingängen ausgewählt. Das unter dieser Adresse gespeicherte 5-bit-Wort wird intern in einen seriellen Pulscode umgeformt und ausgegeben. Durch externe Integration in einem Kondensator kann es in eine äquivalente Analogspannung umgeformt und dem ZF/AFC-Modul zugeführt werden. Zur Festlegung der Betriebsart besitzt der Analogwertspeicher SAB 2022 zwei Eingänge LCA und LCB. Die Betriebsart ist in Abhängigkeit von der Beschaltung der Eingänge in nachfolgender Wahrheitstabelle zusammengestellt.

| Eingänge | | Betriebsart |
|---|---|---|
| LCA | LCB | |
| 1 | 1 | Testbetrieb |
| 0 | 1 | Rückstellen aller internen Flipflops |
| 1 | 0 | Ruhebetrieb (alle Ausgänge auf LOW) |
| 0 | 0 | Normalbetrieb |

Nach der Applikationsschrift des Herstellers soll der Steuereingang LCB direkt oder über einen Widerstand am Bezugspotential (Masse) liegen, falls die ersten beiden Betriebsarten nicht benötigt werden. Der Steuereingang LCA ist mit der übrigen Schaltung verbunden und er liegt über einen 100 KOhm Widerstand an Masse. Der Fernsehempfänger besitzt nun zwei Spannungsversorgungen, wobei eine nur für das Bedienteil ist. Ist diese auch ausgeschaltet, so erhalten die beiden Speicher, nämlich Analogwertspeicher und Programmspeicher, ihre Versorgungsspannung aus der bereits erwähnten aufladbaren Batterie, deren Speicherkapazität 90 mAh beträgt. Nun fließt jedoch über den 100 KOhm-Widerstand 40 µA gegen Masse. Dies würde bedeuten, daß die Kapazität der Batterie ohne Nachladung nach etwa drei Monaten erschöpft ist. Andererseits werden aber zur Erhaltung des Speicherinhalts mindestens 3,3 V benötigt. Da die Programmierung der Speicher beim Hersteller des Fernsehgerätes vorgenommen wird und die Geräte sich oftmals länger als drei Monate auf Lager, beim Transport oder beim Händler befinden, geht der Speicherinhalt verloren.

Aufgabe der vorliegenden Erfindung ist es daher, eine Schaltungsanordnung für eine Fernbedienungseinrichtung nach der eingangs genannten Art zu finden, bei der die Belastung der Batterie in der Betriebsart Ruhezustand (Netz aus) auf ein Minimum reduziert ist, so daß der Speicherinhalt auch ohne Nachladung der Batterie nun für die doppelte Zeit und mehr erhalten bleibt.

Diese Aufgabe wird erfindungsgemäß durch die im kennzeichnenden Teil des Patentanspruches 1 angegebenen Merkmale gelöst.

Die Erfindung erlaubt so eine wesentlich längere Zeit, in der die Speicherdaten gespeichert sind. Eine Begrenzung ist hauptsächlich durch die Selbstentladung der Batterie gegeben.

Die Erfindung wird nachfolgend für ein Ausführungsbeispiel anhand der Zeichnung näher beschrieben.

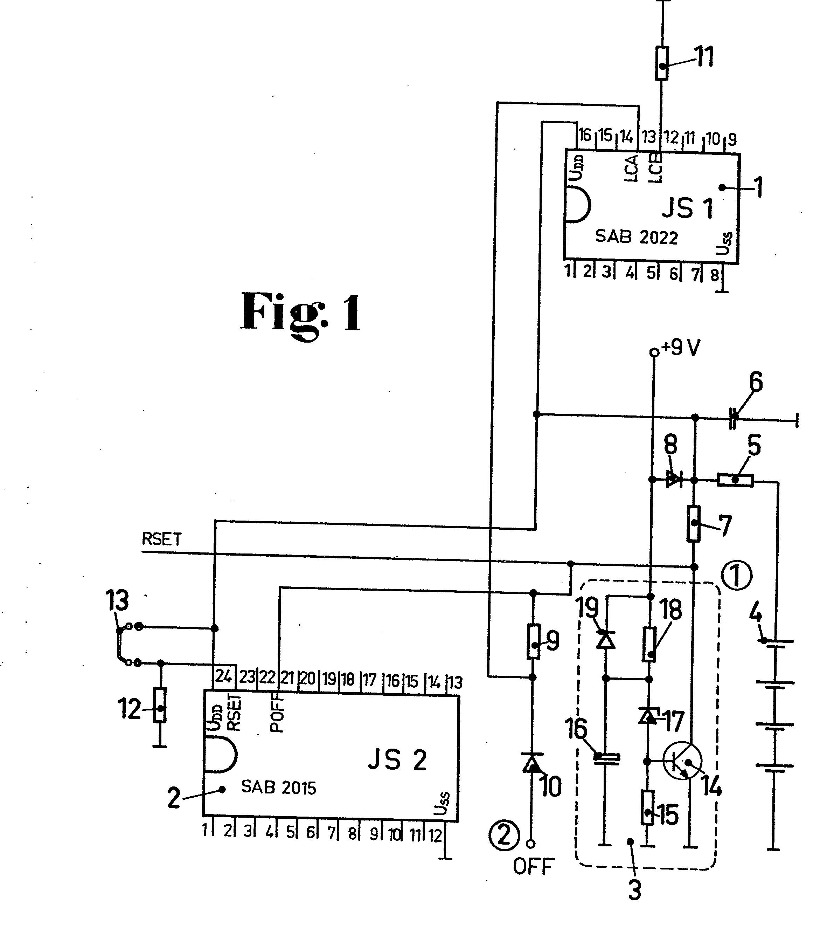

Figur 1 zeigt ein Schaltbild einer Schaltungsanordnung für eine Fernbedienungseinrichtung.

In Figur 1 sind nur die Teile des gesamten TRD-Abstimmsystems dargestellt, die für die Erfindung von Bedeutung sind. Mit 1 ist in Figur 1 der integrierte Schaltkreis SAB 2022 bezeichnet, dessen Funktion bereits in der Beschreibungseinleitung näher angegeben wurde. Die Anschlüsse 12 und 13 stellen die Eingänge LCA und LCB für die Betriebsart dar. Der Anschluß 12 LCB ist über einen Widerstand 11 von 47 KOhm an Bezugspotential bzw. Masse gelegt. Dieser Anschluß kann auch direkt mit Masse verbunden sein, wie es in der Applikationsschrift des Schaltungsherstellers vorgesehen ist. Der andere Anschluß 13 ist über die Widerstände 5, 7 und 9 mit der wiederaufladbaren Batterie 4 verbunden. Die Funktionsweise soll später näher erläutert werden.

Es ist ferner in Figur 1 noch eine Power-ON/Reset-Schaltung vorhanden, die mit 3 bezeichnet ist. Sie besteht aus einem Transistor 14, dessen Emitter an Masse und dessen Kollektor mit dem Widerstand 7 verbunden ist. Die Basis dieses Transistors ist einerseits über einen Widerstand 15 an Masse gelegt, andererseits ist sie mit der Anode einer Zenerdiode 17 verbunden. Die Katode dieser Zenerdiode ist über einen Widerstand 18 mit der Spannungsversorgung der Fernbedienungseinrichtung verbunden. Es wurde eingangs bereits erwähnt, daß der Fernsehempfänger zwei Spannungsversorgungen aufweist, wobei eine nur für die Fernbedienungseinrichtung vorgesehen ist. Dadurch ist es möglich, den Empfänger auszuschalten und nur die Fernbedienungseinrichtung im sogenannten stand-by-Betrieb z.B. zur Erhaltung der Speicherinhalte zu betreiben. Die Katode der Zenerdiode 17 ist ferner noch über eine Kapazität 16 an Masse gelegt und außerdem wird der Widerstand 18 durch die Diode 19 überbrückt. Diese Diode soll beim Ausschalten der Spannungsversorgung oder bei deren Unterbrechung für eine schnelle Entladung des Kondensators 16 sorgen.

Dieser Kondensator 16 und der Widerstand 18 bilden durch deren Zeitkontakte eine Verzögerungsschaltung beim Einschalten der Spannungsversorgung für die Fernbedienungseinrichtung. Die Power ON/Reset-Schaltung dient nämlich zum Zurücksetzen von Registern in einer in Figur 1 nicht dargestellten weiteren integrierten Schaltung, in der unter anderem die Analogspannungen der Betriebswerte, wie z.B. Helligkeit, Lautstärke, Kontrast, Farbsättigung usw., gespeichert sind. Beim Einschalten der Spannungsversorgung gelangt sofort die positive Spannung ($V_H$) an den Reset-Eingang dieser nicht dargestellten integrierten Schaltung. Mit der durch die Zeitkonstante des Widerstandes 18 und der Kapazität 16 festgelegten Zeitverzögerung schaltet der Transistor 14 durch und $V_L$ gelangt an den Reset-Eingang, womit dann eine Nachregelung der auf eine mittlere Größe eingestellten Betriebswerte möglich ist. Die Power ON/Reset-Schaltung dient außerdem als Speicherschutzschaltung, da der Pegel $V_L$ auch an den POFF-Eingang der IS2 gelangt.

Die noch in der Power ON/Reset-Schaltung vorhandene Zenerdiode 17 dient der Spannungsüberwachung der von der Spannungsversorgung gelieferten Spannung, die in Figur 1 mit +9V angegeben ist. Auch der Anschluß, der in Figur 1 mit OFF gekennzeichnet ist, kommt von dieser Spannungsversorgung. Die Diode 10 dient, wie übrigens auch die Diode 8, als Schutz für die Batterie 4, falls die Spannungsversorgung ausgeschaltet ist. Durch diese beiden Dioden ist eine Entkoppelung der Batterie von der Spannungsversorgung gegeben, so daß die Kapazität der Batterie nicht unnötig mehrbelastet wird. Andererseits ist die Diode 8 auf Durchgang gepolt, wenn die Spannungsversorgung eingeschaltet ist und die Batterie wieder aufgeladen wird. Zur Siebung dieser Spannung dient der Kondensator 6, der einerseits mit der Katode der Diode 8 verbunden ist und der andererseits an Masse liegt.

Nachfolgend soll nun die Funktion der Schaltung bei mehreren Betriebszuständen der Versorgungsspannungen erläutert werden. Zum besseren Verständnis hierzu sind in Figur 1 zwei Meßpunkte 1 und 2 ausgewählt worden. Es wurde bereits erwähnt, daß es zwei Spannungsversorgungen gibt. Sind beide eingeschaltet, so liegt am Meßpunkt 1 $V_L$ und am Meßpunkt 2 ebenfalls $V_L$. Damit besitzt auch der Eingang 13 LCA der IS1 $V_L$. Da der Eingang 12 LCB ebenfalls auf $V_L$ liegt, kann aus der eingangs angeführten Wahrheitstabelle entnommen werden, daß sich der Empfänger im Normalbetrieb befindet. Wird nun die Spannungsversorgung des eigentlichen Empfängers abgeschaltet, nicht jedoch die der Fernbedienungseinrichtung, d.h. befindet sich der Empfänger im stand-by-Betrieb, so liegt am Meßpunkt 1 $V_L$ und am Meßpunkt 2 $V_H$. Damit liegt auch am Eingang LCA $V_H$. Wäre nun der gegen Masse geschaltete Widerstand noch vorhanden, so würde die Spannungsversorgung mit einem zusätzlichen Strom belastet. Dies würde nicht ins Gewicht fallen, solange die Spannungsversorgung eingeschaltet ist. Der Strombedarf der IS1 ist vernachlässigbar, wenn der Eingang LCA auf $V_H$ liegt. Sind beide Spannungsversorgungen im Empfänger jedoch ausgeschaltet, so liegt die Batterie mit 4,8 V über die Widerstände 5, 7 und 9 am Eingang LCA der IS1. Die Batterie, die eine wiederaufladbare Nickel-Cadmium-Batterie ist, hat eine Kapazität von 90 mAh. Wäre nun der vom Hersteller der IS empfohlene gegen Masse geschaltete 100 KOhm Widerstand vorhanden, so würde über diesen ein Dauerstrom nach Masse fließen, so daß die Batterie etwa in drei Monaten leer wäre. Da zur Erhaltung des Speicherinhaltes 3,3 V benötigt werden, würde damit auch der Speicherinhalt der IS1 und der IS2 verloren gehen. An dem Meßpunkt 1 stellt sich in diesem Betriebzustand ein Pegel von $V_H$ und am Meßpunkt 2 ein Pegel von $V_L$ ein.

Durch die erfindungsgemäße Schaltungsänderung wird die Belastung der Batterie erheblich reduziert, so daß die Kapazität der Batterie etwa sechs Monate und mehr ausreicht.

Der Eingang 24 der IS2 ist über den Widerstand 5 an die Batterie 4 gelegt. Außerdem kann dieser Eingang bei Batteriewechsel über eine Drahtbrücke 13 mit dem Reset-Eingang 23 der IS2 verbunden werden. Der Reset-Eingang 23 ist über den Widerstand 12 mit Masse verbunden. Im Normalbetrieb besitzt dieser Eingang 23 einen Pegel $V_L$. Nach dem Wechsel der Batterie wird an den Eingang 23 mittels der Drahtbrücke 13 kurzzeitig $V_H$ gelegt und damit die Register in der IS2 zurückgesetzt. Über den Widerstand 12 fließt dann in dieser Zeit ein Strom gegen Masse.

0030329

Preh
Elektrofeinmechanische Werke
Jakob Preh Nachf. GmbH & Co.
Postfach 1740
8740 Bad Neustadt/Saale                    , den 22.11.1979

15/79 Pt.
Bsch/Gü

## Schaltungsanordnung für eine Fernbedienungseinrichtung

1. Schaltungsanordnung für eine Fernbedienungseinrichtung eines Rundfunk- oder Fernsehempfängers mit einer IS als Analogwertspeicher für die Feinabstimmung, mit einer IS als Programmspeicher, mit einer wiederaufladbaren Batterie und mit einer zur Sicherung der Speicherinhalte bestimmten Schaltung, die auch in der Betriebsart Ruhestellung eine Verbindung zwischen Analogwertspeicher bzw. Programmspeicher und der Batterie herstellt, wobei einer der beiden die Betriebsart bestimmenden Steuereingänge des Analogwertspeichers direkt oder über einen Widerstand am Bezugspotential (Masse) liegt, dadurch gekennzeichnet, daß der andere der Steuereingänge nicht gegen das Bezugspotential, sondern nur über Widerstände (5, 7, 9) mit der Batterie (4) verbunden ist derart, daß der Batterie auch in der Betriebsart Ruhestellung kein Strom entnommen wird.

# Fig. 1